# DEMANDE DE BREVET EUROPEEN

(11) **EP 4 164 352 A1**
(43) Date de publication de la demande: **12.04.2023**
(21) Numéro de dépôt: 22195144.5
(22) Date de dépôt: 12.09.2022
(51) Int. Cl.: H05K 7/20

(54) **DISPOSITIF DE CONFINEMENT A STRUCTURE DE TOIT MODULAIRE**

(30) Priorité: 07.10.2021 FR 2110623; 07.10.2021 FR 2110621; 07.10.2021 FR 2110622
(71) Demandeur: Trait d'Union, 44120 Vertou (FR)
(72) Inventeur: MARTY, Pascal, 44120 VERTOU (FR)
(74) Mandataire: Ipsilon

(57) **Abrégé**

Dispositif (1) de confinement pour allée (20) thermique comprenant deux longerons (2) et deux linteaux (3) positionnables entre les longerons (2) à chaque extrémité de l'allée (20) et aptes à former avec lesdits longerons (2) un cadre principal (4), un piétement (5) disposé à l'aplomb de chaque linteau (3) pour un maintien à l'horizontale du cadre principal (4). Le cadre principal (4) est muni d'un remplissage comprenant au moins un panneau (15) et une ossature (13) composée au moins de premiers profilés (14), et de seconds profilés (16). Les premiers profilés (14) forment au moins en coopération avec les longerons (2) et/ou les linteaux du cadre principal (4) à l'intérieur du cadre principal (4) des cadres secondaires (17) coplanaires avec le cadre principal (4), les seconds profilés (16) sont couplables aux premiers profilés (14) ou aux longerons (2) ou aux linteaux pour former avec les premiers profilés (14) ou les longerons (2) ou les linteaux une feuillure (18) en L à l'intérieur de laquelle un panneau (15) est apte à être posé par le dessus du cadre principal (4), à l'état positionné à l'horizontale du cadre principal (4) en appui au sol par ses piétements (5).

## Description

La présente invention concerne un dispositif de confinement pour allée thermique délimitée par deux rangées d'armoires informatiques parallèles.

Elle concerne en particulier un dispositif de confinement comprenant au moins :
- deux longerons positionnables l'un, au-dessus de l'une des rangées d'armoires, l'autre, au-dessus de l'autre des rangées d'armoires,
- deux linteaux positionnables entre les longerons à chaque extrémité de l'allée et aptes à former avec lesdits longerons un cadre dit principal quadrangulaire,
- un piétement disposé à l'aplomb de chaque linteau pour un maintien à l'horizontale du cadre principal à l'état positionné des piétements sur une surface plane horizontale, lesdits piétements formant au moins une partie de parois dites d'extrémité d'une enceinte de confinement à l'état positionné du cadre principal à l'horizontale.

Les centres informatiques comprennent des dispositifs de traitement de l'information (serveurs, disques, réseaux,...) répartis dans des salles de type salle blanche qui doivent répondre à des contraintes spécifiques de sécurisation : température, hygrométrie, protection incendie, risque électromagnétique, contrôle d'accès, Dans une salle informatique, les dispositifs de traitement de l'information sont répartis dans des armoires informatiques encore appelées baies disposées en rangées parallèles. Les dispositifs de traitement de l'information comprennent des climatiseurs et des ventilateurs qui font circuler l'air de la face avant de l'armoire vers la face arrière. Pour assurer la régulation en température, les armoires de deux rangées adjacentes sont agencées avec leurs faces avant en regard l'une de l'autre, et de l'air froid est rejeté entre les rangées, à travers des dalles perforées. On parle dans ce cas d'une allée froide. De manière similaire, une allée chaude correspond à deux rangées dont les armoires sont disposées dos à dos. Bien entendu, une même rangée peut appartenir d'un côté à une allée froide et de l'autre à une allée chaude. On parle alors d'urbanisation en allée froide / allée chaude. Pour améliorer la circulation de l'air froid, et notamment permettre à l'air froid d'atteindre le sommet des armoires, il est recommandé d'équiper une allée froide avec un dispositif de confinement. Le dispositif de confinement habituel comprend un toit rigide fermant le dessus de l'allée et reposant sur le dessus des armoires avec lesquels il est en contact et des portes battantes ou coulissantes aux extrémités de l'allée. Ce type de dispositif de confinement, tel que décrit par exemple dans le brevet FR2949641, présente plusieurs inconvénients. En particulier, toute intervention sur le dessus des armoires nécessite le démontage du dispositif de confinement.

Le toit est en effet, dans ce cas, formé de panneaux adjacents comme le mentionne également le document EP3618598. Il est également connu de réaliser le toit à partir de panneaux pivotants comme l'illustrent la demande de brevet US2020/0217070 ou le brevet EP3163992. Cette solution engendre un encombrement important et une complexité du toit.

Un but de l'invention est de proposer un dispositif de confinement du type précité dont la conception permet à tout moment tout type d'intervention y compris sur le dessus des armoires sans avoir à démonter le dispositif de confinement et sans nuire à la qualité isotherme du confinement.

Un autre but de l'invention est de proposer un dispositif de confinement du type précité dont la conception permet de gérer un effondrement éventuel du dispositif de confinement suite au déclenchement d'un dispositif extincteur anti-incendie générant une projection d'eau ou de gaz inhibiteur sous pression sur le toit de l'enceinte de confinement, ce dispositif extincteur s'étendant au-dessus du dispositif de confinement.

A cet effet, l'invention a pour objet un dispositif de confinement pour allée thermique délimitée par deux rangées d'armoires parallèles, ledit dispositif de confinement comprenant au moins deux longerons positionnables l'un, au-dessus de l'une des rangées d'armoires, l'autre, au-dessus de l'autre des rangées d'armoires, deux linteaux positionnables entre les longerons à chaque extrémité de l'allée et aptes à former avec lesdits longerons un cadre dit principal quadrangulaire, un piétement disposé à l'aplomb de chaque linteau pour un maintien à l'horizontale du cadre principal à l'état positionné des piétements sur une surface plane horizontale, lesdits piétements formant au moins une partie de parois dites d'extrémité d'une enceinte de confinement à l'état positionné du cadre principal à l'horizontale, caractérisé en ce que le cadre principal est muni d'un remplissage comprenant au moins un panneau et une ossature composée au moins de premiers profilés, et de seconds profilés, les premiers profilés formant au moins en coopération avec les longerons et/ou les linteaux du cadre principal, à l'intérieur du cadre principal, des cadres secondaires coplanaires avec le cadre principal, en ce que les seconds profilés sont couplables aux premiers profilés ou aux longerons ou aux linteaux pour former avec les premiers profilés ou les longerons ou les linteaux une feuillure en L à l'intérieur de laquelle un panneau est apte à être posé par le dessus du cadre principal, à l'état positionné à l'horizontale du cadre principal en appui au sol par ses piétements. La présence de cadres secondaires offre une modularité en termes d'agencement du toit et facilite par exemple l'intégration de panneaux d'éclairage. Le fait de faire reposer par le dessus les panneaux sur des feuillures permet de mieux gérer l'effondrement des panneaux sous l'effet d'une charge et autorise un soulèvement des panneaux pour toute intervention.

Selon un mode de réalisation de l'invention, les seconds profilés sont couplables aux premiers profilés ou aux longerons ou aux linteaux par encliquetage, c'est-à-dire par emboitement avec déformation élastique. A nouveau, cette disposition offre la possibilité d'un effondrement aisé des panneaux de toit. En outre, il est ainsi aisé et rapide d'installer des panneaux.

Selon un mode de réalisation de l'invention, les longerons, les premiers profilés ou les linteaux présentent, pour un couplage par encliquetage avec un second profilé, une face tournée vers l'intérieur du cadre secondaire à la délimitation duquel ils participent munie d'une rainure longitudinale à l'intérieur de laquelle un second profilé est configuré pour s'insérer partiellement. Les seconds profilés peuvent être aisément découpés à longueur avec d'être insérés dans une rainure.

Selon un mode de réalisation de l'invention, le cadre principal est bordé longitudinalement par deux bandeaux s'étendant chacun à l'aplomb et au-dessous d'un longeron du cadre principal à l'état positionné à l'horizontale du cadre principal et en position d'appui au sol des piétements sur une surface plane horizontale pour former au moins une partie de parois dites latérales de l'enceinte de confinement, en ce que chaque bandeau est délimité par une lisse parallèle à un longeron et au moins deux montants reliant chacun la lisse au longeron, en ce que les montants , la lisse et le longeron délimitent au moins un cadre dit dormant rempli d'au moins deux éléments de remplissage, en ce qu'au moins l'un des éléments de remplissage est monté mobile à coulissement suivant une direction parallèle aux longerons à l'intérieur du cadre dormant pour un déplacement dudit élément de remplissage entre une position dite ouverte dans laquelle au moins une ouverture d'accès obturable est ménagée dans le bandeau pour permettre depuis l'intérieur de l'enceinte un accès à travers le bandeau à l'extérieur de l'enceinte, et une position fermée. La présence d'un bandeau au niveau de chaque longeron permet une élévation du cadre principal formant le toit de l'enceinte au-dessus du toit des armoires. Au moins l'un des éléments de remplissage du bandeau est monté mobile à coulissement suivant une direction parallèle aux longerons à l'intérieur du cadre dormant pour un déplacement dudit élément de remplissage entre une position dite ouverte dans laquelle au moins une ouverture d'accès obturable est ménagée dans le bandeau pour permettre depuis l'intérieur de l'enceinte un accès à travers le bandeau à l'extérieur de l'enceinte, et une position fermée dans laquelle l'ouverture d'accès ménagée dans ledit bandeau par déplacement à coulissement de l'élément de remplissage est fermée par ledit élément de remplissage. Ainsi, en position ouverte d'au moins l'un des éléments de remplissage, un accès à l'extérieur de l'enceinte au niveau de la zone s'étendant au-dessus des armoires existe tandis qu'en position fermée des éléments de remplissage, l'étanchéité à l'air de l'enceinte est considérée comme de qualité requise comparativement à l'état de la technique.

Selon un mode de réalisation de l'invention, au moins l'un, de préférence chacun des éléments de remplissage est un panneau transparent de type plaque, tel qu'un vitrage. Il en résulte une facilité de mise en œuvre, une utilisation aisée et un coût économiquement acceptable du bandeau.

Selon un mode de réalisation de l'invention, pour au moins l'un des montants de chaque bandeau, le longeron auquel le montant est relié s'étend avec une partie du longeron d'un côté dudit montant du bandeau et avec une autre partie du longeron de l'autre côté du montant, et en ce que le dispositif comprend au moins un câble destiné à être tendu qui relie lesdites parties de longeron entre elles en passant par une extrémité dite inférieure du montant opposée à l'extrémité du montant reliée au longeron. Il est ainsi possible de renforcer la résistance mécanique du longeron en utilisant une partie du bandeau. Le risque de prise de flèche du longeron est ainsi nul. Cette conception permet également la réalisation d'un dispositif de confinement avec des longerons de grande longueur. Cette architecture permet ainsi d'allier modularité et grande dimension du remplissage du cadre principal.

Selon un mode de réalisation de l'invention, les parties de longeron qui s'étendent l'une, d'un côté, l'autre, de l'autre côté du montant du bandeau forment un ensemble non monobloc et sont assemblées l'une à l'autre au niveau du montant qui s'étend à l'aplomb et au-dessous de la zone de liaison desdites parties à l'état positionné à l'horizontale du cadre principal. La présence du ou des câbles permet de réaliser chaque longeron sous forme d'un assemblage pour accroître encore la longueur de longeron possible.

Selon un mode de réalisation de l'invention, le câble est équipé d'au moins un organe de tension du câble, tel qu'un ridoir.

Selon un mode de réalisation de l'invention, l'extrémité inférieure du montant est munie d'une gorge à l'intérieur de laquelle le câble est apte à s'insérer. Cette conception permet de manière simple un maintien fiable du câble.

Selon un mode de réalisation de l'invention, la lisse d'au moins l'un des bandeaux présente, sur sa partie tournée vers le sol à l'état positionné à l'horizontale du cadre principal reposant au sol par ses piétements, une glissière formant rail pour permettre la réception d'éléments d'habillage de paroi. A nouveau, cette disposition permet de manière simple un maintien d'éléments d'habillage de paroi, ces éléments d'habillage pouvant être nécessaires dans le cas d'une hauteur des armoires d'une rangée d'armoires non identique d'une armoire à une autre de ladite rangée.

### Brève description des dessins

L'invention sera bien comprise à la lecture de la description suivante d'exemples de réalisation, en référence aux dessins annexés dans lesquels :
[Fig. 1] représente une vue en perspective en élévation d'un dispositif de confinement conforme à l'invention à l'état délimité d'une allée thermique par deux rangées d'armoires ;
[Fig. 2] représente une vue en perspective d'un dispositif de confinement seul sans les armoires, conforme à l'invention ;
[Fig. 3] représente une vue de dessus d'un dispositif de confinement avec une vue de détail ;
[Fig. 4] représente une vue en coupe transversale d'un dispositif de confinement ;
[Fig. 5] représente une vue partielle en perspective d'un dispositif de confinement prise au niveau d'un bandeau avec le bandeau à l'état ouvert de l'un des éléments de remplissage ;
[Fig. 6] représente une vue partielle en perspective d'un dispositif de confinement prise au niveau d'un bandeau avec le bandeau à l'état fermé du bandeau.

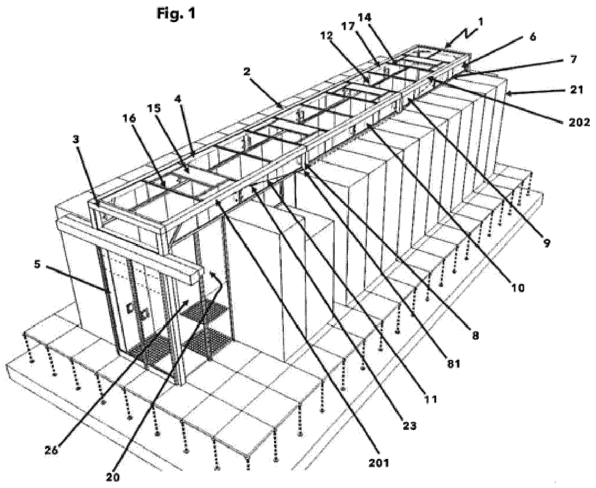

La figure 1 représente une allée 20 froide d'une salle informatique. L'allée froide comprend une pluralité d'armoires 21.

Comme on peut le voir sur la figure 1, les armoires 21 présentent des hauteurs différentes. Elles sont disposées en deux rangées parallèles. Le sol entre les rangées est composé de dalles perforées à travers lesquelles de l'air froid peut être rejeté dans l'allée 20 froide.

Chacune des armoires 21 présente une face avant tournée vers le centre de l'allée 20 froide et une face arrière tournée vers l'extérieur de l'allée 20 froide.

Les ventilateurs agencés dans les armoires 21 permettent de faire circuler l'air froid à travers les armoires 21, de leur face avant vers leur face arrière, ce qui permet l'évacuation de la chaleur.

Cependant, la circulation de l'air froid dans l'allée froide peut être perturbée et empêcher le refroidissement des parties supérieures des armoires 21. Par exemple si le plafond de la salle informatique est trop bas, un phénomène de bouclage peut entraîner de l'air chaud de la face arrière vers la face avant. Le soufflage d'air froid peut aussi être gêné par un encombrement filaire important sous les dalles.

C'est notamment pour ces raisons qu'un dispositif 1 de confinement est installé.

Le dispositif 1 de confinement permet de fermer l'allée 20 froide et donc, d'assurer une meilleure circulation de l'air de refroidissement.

Un tel dispositif 1 de confinement comprend deux longerons 2 et deux linteaux 3, assemblables entre eux pour former un cadre appelé cadre principal 4.

Ce cadre est de forme rectangulaire. Les longerons 2 et les linteaux 3 peuvent être formés par des profilés métalliques, par exemple en aluminium.

Les longerons 2 sont destinés à être positionnés l'un au-dessus de l'une des rangées d'armoires 21, l'autre au-dessus de l'autre des rangées d'armoires 21, tandis que les linteaux sont destinés à être positionnés l'un à l'une des extrémités de l'allée 20, l'autre à l'autre des extrémités de l'allée 20, comme illustré à la figure 1.

Le dispositif 1 de confinement comprend encore un piètement 5 disposé à l'aplomb de chaque linteau 3 pour un maintien à l'horizontale du cadre principal 4 à l'état positionné sur une surface plane horizontale desdits piètements.

Les piètements 5 forment au moins une partie de paroi dite d'extrémité d'une enceinte 19 de confinement à l'état positionné du cadre principal 4 à l'horizontale.

Chaque piètement 5 est ici formé de deux pieds disposés aux extrémités d'un linteau pour s'étendre l'un à l'un des angles du cadre principal 4, l'autre au niveau d'un autre des angles du cadre principal 4. Ces pieds forment la partie d'un dormant servant à la réception d'un ouvrant, tel qu'un ouvrant formé de deux vantaux coulissants, comme illustré à la figure 1. Ces vantaux constituent des portes fermant les extrémités de l'allée 20.

Le cadre principal 4 est muni d'un remplissage 12 qui repose sur le cadre principal 4 à l'état positionné du cadre principal 4 à l'horizontale. Ce remplissage 12 comprend des panneaux 15 et une ossature 13 composée au moins de premiers profilés 14 et de seconds profilés 16.

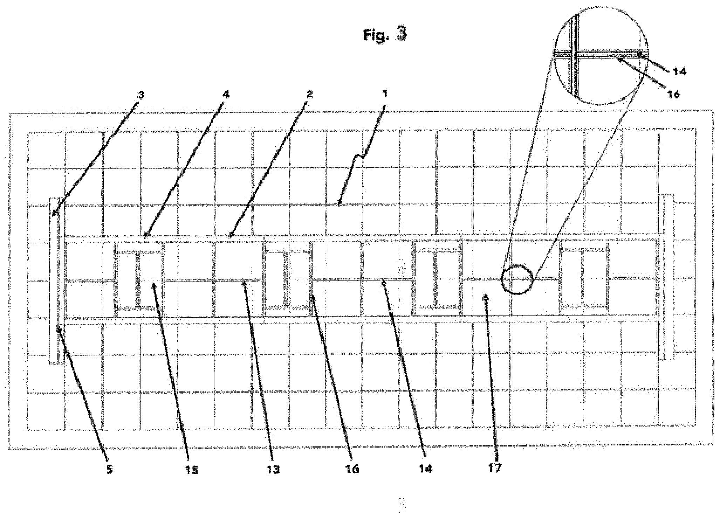

Les premiers profilés 14 sont assemblés au moins aux longerons 2 et/ou aux linteaux 3 du cadre principal 4 et éventuellement entre eux pour former des cadres secondaires 17 de géométrie variable. Tel est le cas de l'exemple représenté à la figure 3. Ainsi, un cadre secondaire peut indifféremment être formé de deux longerons et de deux premiers profilés ou de deux linteaux et de deux premiers profilés ou d'un longeron, de deux linteaux et d'un premier profilé ou de deux longerons, d'un linteau, et un premier profilé, ou de premiers profilés, ou de trois premiers profilés et d'un longeron ou de trois premiers profilés et d'un linteau ou de deux premiers profilés et d'un longeron et d'un linteau notamment.

Les seconds profilés 16 sont couplables aux premiers profilés 14 ou aux longerons 2 ou aux linteaux 3 pour former, avec les premiers profilés 14 ou les longerons 2 ou les linteaux 3 une feuillure 18 en L à l'intérieur de laquelle un panneau 15 est apte à être posé.

Idéalement, les seconds profilés 16 sont couplables aux premiers profilés 14 ou aux longerons 2 ou aux linteaux 3 par encliquetage, c'est-à-dire par emboîtement avec déformation élastique.

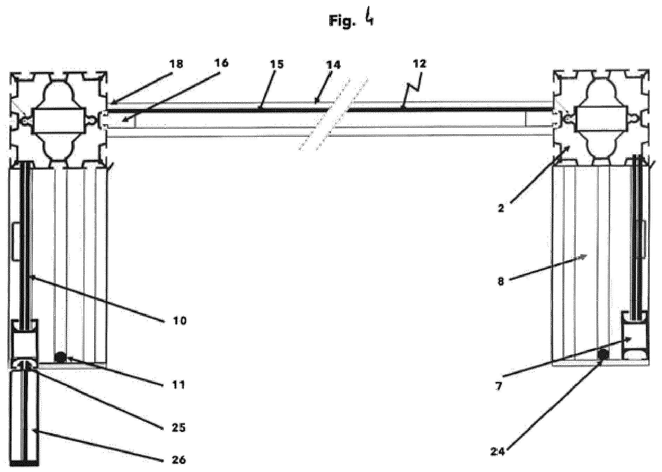

Ces seconds profilés 16, tels qu'illustrés à la figure 4, peuvent se présenter sous forme d'un corps creux polygonal muni sur l'une de ses tranches d'une double languette longitudinale apte à s'insérer dans une rainure longitudinale du premier profilé ou du longeron ou du linteau avec lequel le second profilé 16 est assemblé.

Cette rainure longitudinale est ménagée dans un flanc du premier profilé ou du longeron ou du linteau. Ainsi, le flanc du premier profilé ou du longeron ou du linteau et le second profilé forment entre eux les branches d'un L pour former la feuillure 18 en L de réception d'un panneau 15 qui est posé par le haut sur le cadre principal à l'état positionné du cadre principal 4 à l'horizontale et reposant en appui au sol par ses piètements 5. La nature de chaque panneau 15 peut être diverse et variée. Un tel panneau 15 peut être équipé d'organes d'éclairage ou non au d'autres organes. Un tel panneau 15 peut être transparent ou translucide ou autre.

Cette conception permet une grande modularité dans la composition du remplissage, et il est aisé de recomposer ce remplissage.

Le cadre principal 4 est bordé longitudinalement par deux bandeaux 6 s'étendant chacun à l'aplomb et au-dessous d'un longeron 2 du cadre principal 4 à l'état positionné à l'état horizontal du cadre principal 4 et en position d'appui au sol des piètements 5 sur une surface plane horizontale, pour former au moins une partie de parois dites latérales de l'enceinte 19 de confinement.

Chaque bandeau 6 est délimité par une lisse 7 parallèle à un longeron 2 et au moins deux montants 8 reliant chacun la lisse 7 au longeron 2.

Les montants 8, la lisse 7 et le longeron 2 délimitent au moins un cadre dit dormant 9 rempli d'au moins deux éléments 10 de remplissage.

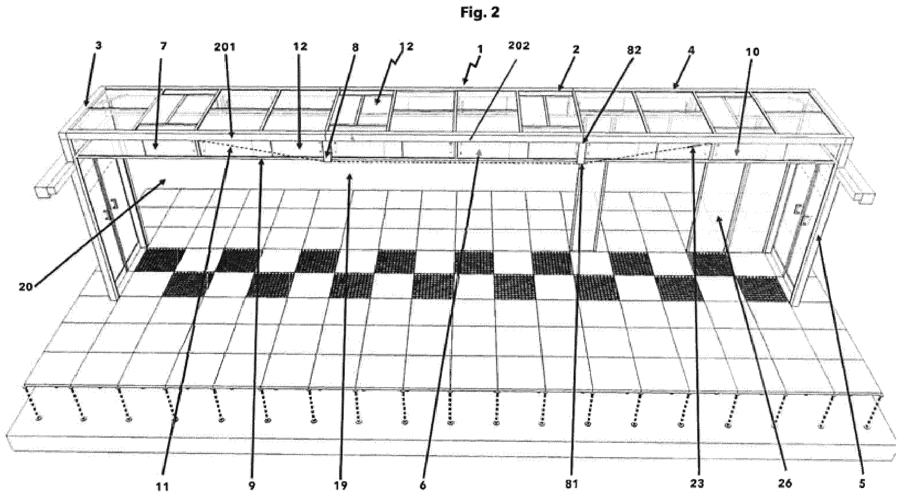

Dans l'exemple représenté à la figure 2, le bandeau 6 comprend deux montants 8 d'extrémité et deux montants 8 intermédiaires, de sorte que trois cadres dormants 9 sont ménagés, à savoir deux cadres dormants avec à chaque fois un montant d'extrémité et un montant intermédiaire, et le troisième cadre dormant 9 avec deux montants intermédiaires.

Chaque cadre dormant 9 est rempli par deux éléments 10 de remplissage. Chacun des éléments 10 de remplissage est un panneau transparent de type plaque, tel qu'un vitrage. Chaque élément 10 de remplissage est, dans les exemples représentés, un élément 10 de remplissage coulissant monté mobile à coulissement suivant une direction parallèle au longeron 2, à l'intérieur du cadre 9 dormant, pour un déplacement dudit élément 10 de remplissage entre une position dite ouverte dans laquelle au moins une ouverture 22 d'accès obturable est ménagée dans le bandeau 6 pour permettre, depuis l'intérieur de l'enceinte 19, un accès à travers le bandeau 6 à l'extérieur de l'enceinte 19, et une position fermée dans laquelle l'ouverture d'accès ménagée dans ledit bandeau en position ouverte de l'élément de remplissage est fermée.

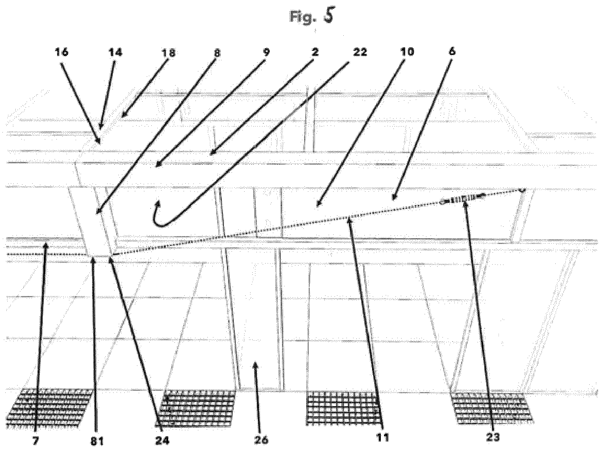

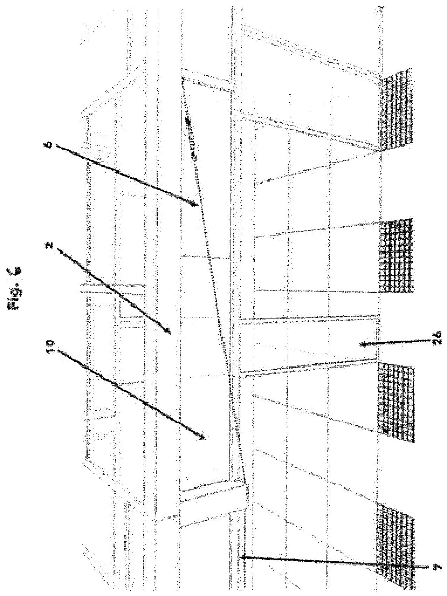

Ce passage de la position ouverte à la position fermée d'un élément 10 de remplissage est illustré aux figures 5 et 6, où la figure 5 représente l'un des éléments 10 de remplissage en position ouverte et la figure 6 représente ledit élément 10 de remplissage en position fermée. Le passage d'une position à une autre s'opère par simple déplacement à coulissement de l'élément 10 de remplissage.

Pour faciliter ces déplacements, chaque élément de remplissage est équipé d'une poignée de saisie côté face dite interne du bandeau, c'est-à-dire face du bandeau 6 tournée vers l'intérieur de l'enceinte de confinement.

Chaque bandeau 6 est, comme le longeron 2 qu'il intègre, disposé au-dessus et à l'aplomb d'une rangée d'armoires 21.

Ainsi, la possibilité de ménager une ouverture à travers le bandeau 6 permet d'accéder, depuis l'intérieur de l'enceinte, au-dessus des armoires 21, ce qui s'avère particulièrement important en cas d'intervention sur le dessus des armoires, sans nuire à la qualité de l'isolation à l'air du dispositif 1 de confinement en position fermée des éléments 10 de remplissage.

On note que pour au moins l'un des montants 8 de chaque bandeau 6, le longeron 2 auquel le montant est relié s'étend avec une partie 201 du longeron 2 d'un côté dudit montant 8 du bandeau 6 et avec une autre partie 202 du longeron 2 de l'autre côté dudit montant 8.

Le dispositif 1 de confinement comprend par ailleurs au moins un câble 11 qui relie lesdites parties 201 et 202 de longeron 2 entre elles en passant par une extrémité 81 dite inférieure du montant 8 opposée à l'extrémité 82 du montant 8 relié au longeron 2.

Le câble 11 est équipé d'au moins un organe 23 de tension du câble, tel qu'un ridoir. Dans les exemples représentés, le câble est équipé au niveau de chacune de ses extrémités, d'un organe 23 de tension.

La tension du câble 11 permet d'éviter une prise de flèche du longeron 2, en particulier quand le longeron 2 est de grande longueur.

Dans l'exemple représenté à la figure 2, une extrémité du câble est fixée à la partie du longeron s'étendant entre un montant d'extrémité et le montant intermédiaire le plus proche, tandis que l'autre extrémité du câble est fixée au longeron au niveau de la partie du câble s'étendant entre l'autre montant d'extrémité du bandeau et le montant intermédiaire le plus proche dudit montant d'extrémité.

Entre ces deux extrémités de câble fixées chacune à une partie de longeron, le câble passe sous chaque extrémité inférieure de chaque montant intermédiaire pour tendre à exercer au niveau de chaque montant intermédiaire une force de poussée verticale ascendante sur lesdits montants à l'état positionné à l'horizontale du cadre principal pour venir compenser la flèche naturelle apte à être prise par le longeron.

Le câble est, dans les exemples représentés, un câble 11 métallique. Pour s'assurer d'un maintien en position du câble au niveau de l'extrémité inférieure 81 de chaque montant 8 intermédiaire, l'extrémité inférieure 81 du montant 8 est munie d'une gorge 24 à l'intérieur de laquelle le câble 11 est apte à s'insérer. Les flancs de la gorge 24 s'étendent parallèlement à l'axe longitudinal du longeron 2. Cette gorge 24 est plus particulièrement visible à la figure 4.

Le longeron 2 peut être réalisé d'une seule pièce et s'étendre sous forme d'un élément ininterrompu d'une extrémité à l'autre dudit longeron.

En variante, et dans l'exemple représenté, les parties 201, 202 de longeron 2 qui s'étendent, l'une d'un côté, l'autre de l'autre côté d'un montant 8 intermédiaire du bandeau 6 forment un ensemble non monobloc et sont assemblées l'une à l'autre au niveau du montant 8 intermédiaire qui s'étend à l'aplomb et au-dessous de la zone de liaison desdites parties 201, 202 de longeron à l'état positionné à l'horizontale du cadre principal 4.

Ainsi, dans l'exemple représenté à la figure 2, si on considère le montant 8 intermédiaire le plus à gauche de la figure 2, on constate que les parties 201 et 202 de longeron présentent une zone de liaison située au-dessus et à l'aplomb du montant 8 intermédiaire à l'état positionné à l'horizontale du cadre principal 4.

En outre, au moins l'une des parties de longeron est elle-même formée d'une pluralité de sections de longeron alignées. Tel est le cas dans l'exemple de la partie de longeron représentée en 202, qui est formée depuis le montant 8 intermédiaire de deux sections de longeron qui sont liées l'une à l'autre au niveau de l'autre montant 8 intermédiaire du longeron 2.

Il doit être noté que la présence d'un câble qui assure une précontrainte du longeron permet, y compris pour une grande longueur de longeron, la réalisation d'un dispositif de confinement sous forme d'une structure autoportante ne nécessitant aucune liaison à la salle informatique.

En variante, le cadre principal 4 peut être, en complément des piètements qui le supportent, suspendu au plafond de la salle informatique.

Dans le cas où les armoires 21 d'une même rangée ne sont pas toutes de même hauteur ou absentes, il est possible de prévoir des éléments d'habillage de paroi 26 qui viennent combler l'espace laissé vide, soit entre le sol et la lisse du bandeau en l'absence d'armoire, soit entre le dessus d'armoire et la lisse du bandeau en présence d'une armoire de hauteur insuffisante. Ces éléments d'habillage de paroi 26 peuvent se présenter sous forme de simples panneaux, vitrés ou non.

Pour faciliter le maintien de ces éléments d'habillage de paroi 26 de type panneaux à l'état dressé, la lisse 7 d'au moins l'un des bandeaux présente, sur sa partie tournée vers le sol à l'état positionné à l'horizontale du cadre principal 4 reposant au sol par ses piètements 5, une glissière formant rail 25 pour permettre la réception des éléments d'habillage de paroi 26.

La glissière formant rail 25 permet également un repositionnement par simple coulissement à l'intérieur de la glissière formant rail 25 des éléments d'habillage de paroi 26.

En pratique, le montage d'un tel dispositif 1 de confinement s'opère comme suit : les longerons 2 et les linteaux 3 sont assemblés entre eux pour former le cadre principal 4. Les lisses des bandeaux sont reliées aux longerons 2 par les montants 8. Ainsi, chaque montant 8 qui comprend une extrémité inférieure et une extrémité supérieure est relié par son extrémité inférieure à la lisse, et par son extrémité supérieure au longeron, et les éléments de remplissage sont disposés entre lisse et longeron.

Le cadre principal 4 et les piètements 5 couplés au cadre principal 4 sont, avec les bandeaux, mis en place dans l'allée thermique.

Le remplissage 12 du cadre principal 4 peut ensuite être installé. L'opérateur peut, à l'aide des premiers profilés en lien avec les longerons et les linteaux, réaliser autant de cadres secondaires que souhaité. Les seconds profilés peuvent alors être rapportés sur les premiers profilés ou les longerons ou les linteaux pour fermer à chaque fois une feuillure en L. Un panneau peut alors être posé sur les seconds profilés par le dessus du cadre principal à l'état positionné à l'horizontal du cadre principal en appui au sol par ses piètements.

Les éléments d'habillage de paroi 26 sont également disposés si nécessaire.

Quand un accès au-dessus d'une armoire est nécessaire, il suffit de déplacer à coulissement l'élément de remplissage du bandeau disposé au-dessus de cette armoire pour l'amener en position ouverte et avoir accès au-dessus de l'armoire. Quand un extincteur se déclenche, les panneaux de remplissage du cadre principal peuvent aisément s'effondrer. Enfin, chaque panneau peut être aisément soulevé depuis l'intérieur de l'enceinte de confinement.

## Revendications

1. Dispositif (1) de confinement pour allée (20) thermique délimitée par deux rangées d'armoires (21) parallèles, ledit dispositif (1) de confinement comprenant au moins deux longerons (2) positionnables l'un, au-dessus de l'une des rangées d'armoires, l'autre, au-dessus de l'autre des rangées d'armoires (21), deux linteaux (3) positionnables entre les longerons (2) à chaque extrémité de l'allée (20) et aptes à former avec lesdits longerons (2) un cadre dit principal (4) quadrangulaire, un piétement (5) disposé à l'aplomb de chaque linteau (3) pour un maintien à l'horizontale du cadre principal (4) à l'état positionné des piétements sur une surface plane horizontale, lesdits piétements (5) formant au moins une partie de parois dites d'extrémité d'une enceinte (19) de confinement à l'état positionné du cadre principal (4) à l'horizontale , **caractérisé en ce que** le cadre principal (4) est muni d'un remplissage comprenant au moins un panneau (15) et une ossature (13) composée au moins de premiers profilés (14), et de seconds profilés (16), les premiers profilés (14) formant au moins en coopération avec les longerons (2) et/ou les linteaux du cadre principal (4), à l'intérieur du cadre principal (4), des cadres secondaires (17) coplanaires avec le cadre principal (4), **en ce que** les seconds profilés (16) sont couplables aux premiers profilés (14) ou aux longerons (2) ou aux linteaux pour former avec les premiers profilés (14) ou les longerons (2) ou les linteaux une feuillure (18) en L à l'intérieur de laquelle un panneau (15) est apte à être posé par le dessus du cadre principal (4), à l'état positionné à l'horizontale du cadre principal (4) en appui au sol par ses piétements (5).

2. Dispositif (1) de confinement pour allée (20) thermique selon la revendication 1, **caractérisé en ce que** les seconds profilés (16) sont couplables aux premiers profilés (14) ou aux longerons (2) ou aux linteaux par encliquetage, c'est-à-dire par emboitement avec déformation élastique.

3. Dispositif (1) de confinement pour allée (20) thermique selon la revendication 2, **caractérisé en ce que** les longerons (2), les premiers profilés (14) ou les linteaux présentent, pour un couplage par encliquetage avec un second profilé (16), une face tournée vers l'intérieur du cadre secondaire (17) à la délimitation duquel ils participent munie d'une rainure longitudinale à l'intérieur de laquelle un second profilé (16) est configuré pour s'insérer partiellement.

4. Dispositif (1) de confinement pour allée (20) thermique selon l'une des revendications 1 à 3, **caractérisé en ce que** le cadre principal (4) est bordé longitudinalement par deux bandeaux (6) s'étendant chacun à l'aplomb et au-dessous d'un longeron (2) du cadre principal (4) à l'état positionné à l'horizontale du cadre principal (4) et en position d'appui au sol des piétements (5) sur une surface plane horizontale pour former au moins une partie de parois dites latérales de l'enceinte (19) de confinement, **en ce que** chaque bandeau (6) est délimité par une lisse (7) parallèle à un longeron (2) et au moins deux montants (8) reliant chacun la lisse (7) au longeron (2), **en ce que** les montants (8), la lisse (7) et le longeron (2) délimitent au moins un cadre dit dormant (9) rempli d'au moins deux éléments (10) de remplissage, **en ce qu'**au moins l'un des éléments (10) de remplissage est monté mobile à coulissement suivant une direction parallèle aux longerons (2) à l'intérieur du cadre dormant (9) pour un déplacement dudit élément (10) de remplissage entre une position dite ouverte, dans laquelle au moins une ouverture d'accès (22) obturable est ménagée dans le bandeau pour permettre, depuis l'intérieur de l'enceinte (19), un accès à travers le bandeau (6) à l'extérieur de l'enceinte (19), et une position fermée.

5. Dispositif (1) de confinement pour allée (20) thermique selon la revendication 4, **caractérisé en ce qu'**au moins l'un, de préférence chacun des éléments (10) de remplissage est un panneau transparent de type plaque, tel qu'un vitrage.

6. Dispositif (1) de confinement pour allée (20) thermique selon l'une des revendications 4 ou 5, **caractérisé en ce que**, pour au moins l'un des montants (8) de chaque bandeau (6), ledit longeron (2) auquel le montant est relié s'étend avec une partie (201) du longeron (2) d'un côté dudit montant du bandeau (6) et avec une autre partie (202) du longeron (2) de l'autre côté du montant (8), et **en ce que** le dispositif (1) comprend au moins un câble (11) destiné à être tendu qui relie lesdites parties (201, 202) de longerons (2) entre elles en passant par une extrémité dite inférieure du montant (8) opposée à l'extrémité du montant (8) reliée au longeron (2).

7. Dispositif (1) de confinement pour allée (20) thermique selon la revendication 6, **caractérisé en ce que** les parties (201, 202) de longeron (2) qui s'étendent l'une, d'un côté, l'autre, de l'autre côté du montant du bandeau (6) forment un ensemble non monobloc et sont assemblées l'une à l'autre au niveau du montant (8) qui s'étend à l'aplomb et au-dessous de la zone de liaison desdites parties à l'état positionné à l'horizontale du cadre principal (4).

8. Dispositif (1) de confinement pour allée (20) thermique selon l'une des revendications 6 ou 7, **caractérisé en ce que** le câble (11) est équipé d'au moins un organe de tension (23) du câble (11), tel qu'un ridoir.

9. Dispositif (1) de confinement pour allée (20) thermique selon l'une des revendications 6 à 8, **caractérisé en ce que** l'extrémité inférieure du montant (8) est munie d'une gorge (24) à l'intérieur de laquelle le câble (11) est apte à s'insérer.

10. Dispositif (1) de confinement pour allée (20) thermique selon l'une des revendications 4 à 9, **caractérisé en ce que** la lisse (7) d'au moins l'un des bandeaux (6) présente, sur sa partie tournée vers le sol à l'état positionné à l'horizontale du cadre principal (4) reposant au sol par ses piétements (5), une glissière (25) formant rail pour permettre la réception d'éléments d'habillage de paroi (26).
